# EUROPEAN PATENT APPLICATION

(11) **EP 1 602 996 A1**
(43) Date of publication of application: **07.12.2005**
(21) Application number: 05011744.9
(22) Date of filing: 31.05.2005
(51) Int. Cl.: G05F 1/56, H03F 3/183

(54) **Voltage-controlled current source capable of controlling output current by a wide range of control voltage**

(30) Priority: 03.06.2004 JP 2004165912
(71) Applicant: ALPS ELECTRIC CO., LTD., Tokyo 145-8501 (JP)
(72) Inventor: Ota, Masahiko, Otsuka-cho Ota-ku Tokyo 145-8501 (JP)
(74) Representative: Klunker . Schmitt-Nilson . Hirsch

(57) **Abstract**

A voltage-controlled current source includes an FET mirror connection circuit in which a gate and a drain of a first FET are connected to each other and a gate of a second FET is commonly connected to a connection point between the gate and the drain of the first FET; a third FET which has a source load and which is source-follower connected; a fourth FET of which a gate and a source are directly connected to each other and a connection point between the gate and the drain is connected to a source of the third FET to become the source load; and a fifth FET for inverting a voltage of which a gate is connected to a source of the third FET and a drain is connected to the common connection point of the FET mirror connection circuit. In the voltage-controlled current source, a control voltage is applied to the gate of the third FET, and an output current corresponding to the control voltage is derived from the drain of the second FET.

## Description

### BACKGROUND OF THE INVENTION

### 1. Field of the Invention

The present invention relates to an FET voltage-controlled current source of deriving an output current corresponding to a control voltage, and particularly, to an FET voltage-controlled current source which derives an output current changing between a minimum current value and a maximum current value in correspondence with a control voltage changing between a power voltage value and a ground voltage value.

### 2. Description of the Related Art

Generally, as an FET voltage-controlled current source composed of FETs, an FET voltage-controlled current source having an FET mirror connection circuit composed of a first FET, of which a drain and a gate are directly connected to each other, and a second FET, of which a gate is commonly connected to the direct connection point between the drain and the gate of the first FET, has been known.

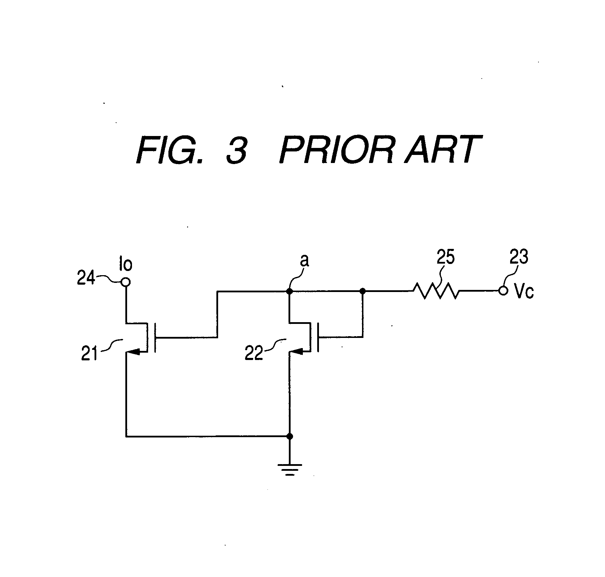

Here, Fig. 3 is a circuit diagram showing an example of a configuration of such a known FET voltage-controlled current source.

As shown in Fig. 3, the FET voltage-controlled current source has a first FET 21, a second FET 22, an input control terminal 23, and a current output terminal 24. A drain and a gate of the first FET 21 are directly connected to each other, the connection point a between the drain and the gate of the first FET is connected to the input control terminal 23, and a source of the first FET 21 is grounded. A drain of the second FET 22 is commonly connected to the connection point a, a drain of the second FET is connected to the current output terminal 24, and a source of the second FET is grounded. In addition, a control voltage Vc is inputted to a buffer resistor via the input control terminal 23 and an output current Io is derived from the current output terminal 24.

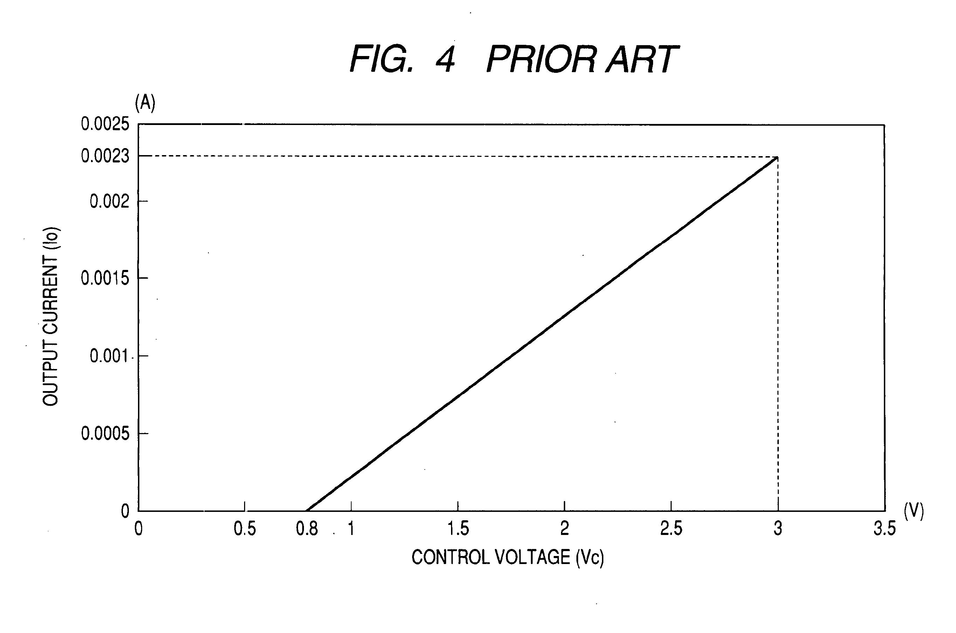

Next, Fig. 4 is a characteristic diagram showing a relationship between the output current Io and the control voltage Vc controlled by an FET voltage-controlled current source shown in Fig. 3.

In Fig. 4, the horizontal axis is a control voltage Vc expressed in volts (V) and the vertical axis is an output current Io expressed in amperes (A).

Here, operation of the FET voltage-controlled current source shown in Fig. 3 will be described. Fig. 4 is used in combination with Fig. 3 to describe the operation.

When a control voltage Vc is applied to the input control terminal 23, till the control voltage Vc reaches the threshold voltage Vth (about 0.8 V in the example of the characteristic diagram shown in Fig. 4) of the FET voltage-controlled current source, the first FET 21 and the second FET 22 exist in a cut-off state. Accordingly, drain currents do not flow in both the first FET 21 and the second FET 22. As a result, an output current is not derived from the current output terminal 24.

Further, when the control voltage Vc applied to the input control terminal 23 exceeds the threshold voltage Vth, each of the first FET 21 and the second FET 22 is turned to an on state. Accordingly, drain currents flow in both the first FET 21 and the second FET 22. As a result, an output current is derived from the current output terminal 24. In this case, as the control voltage Vc gets higher after exceeding the threshold voltage Vth, the on state of each of the first FET 21 and the second FET 22 progresses and the drain currents flowing in both the first FET 21 and the second FET 22 becomes large. Accordingly, the output current Io derived from the current output terminal 24 becomes large linearly with regard to the control voltage Vc.

Furthermore, when the control voltage Vc applied to the input control terminal 23 reaches a maximum value equal to the power voltage V_{DD} (3.0 V in the example of the characteristic diagram shown in Fig. 4), the output current Io derived from the current output terminal 24 becomes a maximum value (0.0023A in the example of the characteristic diagram shown in Fig. 4). As a result, when the control voltage Vc changes between the threshold voltage Vth (about 0.7V) and the maximum value (3.0V), the output current Io changes between the minimum value (0.0A) and the maximum value (0.0023A). Therefore, it is possible to derive the output current Io corresponding to the control voltage Vc.

In the meantime, since the known FET voltage-controlled current source can derive the output current Io corresponding to the control voltage Vc, but the output current Io is not derived till the control voltage Vc exceeds the threshold voltage Vth, even though the control voltage Vc changes in a range of the threshold voltage Vth (about 0.8V) or less, a dead area of the control voltage Vc where the output current Io is zero exists. The dead area of the control voltage Vc is equivalent to a little less than 30 percents of the variable range of the control voltage Vc. Therefore, at that rate, the variable range of the control voltage Vc changing the output current Io is limited. As a result, it is difficult to control the output current Io of the FET voltage-controlled current source by a wide range of the control voltage Vc.

### SUMMARY OF THE INVENTION

The present invention has been finalized in such a technical background, and it is an object of the present invention to provide a voltage-controlled current source in which an output current can be controlled by a wide range of control voltage by eliminating a dead area of the control voltage.

In order to achieve the object, a voltage-controlled current source according to the invention includes an FET mirror connection circuit in which a gate and a drain of a first FET are connected to each other and a gate of a second FET is commonly connected to a connection point between the gate and the drain of the first FET; a third FET which has a source load and which is source-follower connected; a fourth FET of which a gate and a source are directly connected to each other and a connection point between the gate and the drain is connected to a source of the third FET to become the source load; and a fifth FET for inverting a voltage of which a gate is connected to a source of the third FET and a drain is connected to the common connection point of the FET mirror connection circuit. In the voltage-controlled current source, a control voltage is applied to the gate of the third FET and an output current corresponding to the control voltage is derived from the drain of the second FET.

In the voltage-controlled current source according to the invention, it is preferable that the control voltage change between a ground voltage value and a power voltage value, and the output current change between a maximum current value and a minimum current value corresponding to the change of the control voltage.

As mentioned above, according to the voltage-controlled current source of the invention, the third FET which is source-follower connected, the fourth FET becoming the source load of the third FET, and the fifth FET for inverting the voltage are connected to each other at a previous stage side of the FET mirror connection circuit composed of the first FET and the second FET. Accordingly, it is possible to eliminate the dead area where the output current does not change even though the control voltage changes. As a result, it is possible to operate the voltage-controlled current source such that the output current changes between the maximum current value and the minimum current in correspondence with the change of the control voltage, and thus the output current can be controlled by a wide range of control voltage.

### BRIEF DESCRIPTION OF THE DRAWINGS

Fig. 1 is a circuit diagram showing an example of a configuration of a voltage-controlled current source according to a preferred embodiment of the present invention;
Fig. 2 is a characteristic diagram showing the relationship between an output current and a control voltage controlled by the FET voltage-controlled current source shown in Fig. 1;
Fig. 3 is a circuit diagram showing an example of a configuration of a well-known FET voltage-controlled current source; and
Fig. 4 is a characteristic diagram showing the relationship between an output current and a control voltage controlled by the FET voltage-controlled current source shown in Fig. 3.

### DESCRIPTION OF THE PREFERRED EMBODIMENTS

Preferred embodiments of the invention will now be described with reference to the drawings.

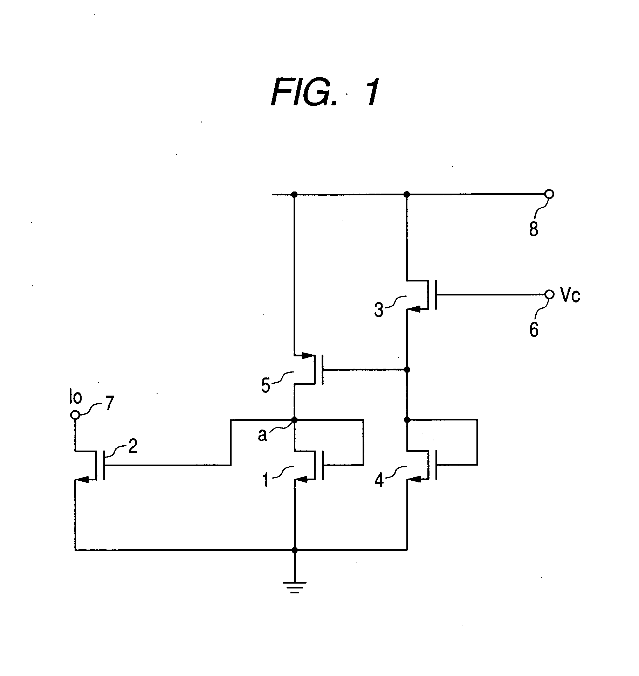

Fig. 1 is a circuit diagram showing an example of a configuration of an embodiment of a voltage-controlled current source according to the invention.

As shown in Fig. 1, the voltage-controlled current source according to the embodiment has a first FET 1 and a second FET 2 constituting a FET mirror connection circuit, a third FET 3 constituting a source follower circuit, a forth FET 4 constituting a source load, a fifth FET 5 constituting a voltage inverting circuit, a input control terminal 6, a current output terminal 7, and a power terminal 8.

In this case, a drain and a gate of the first FET 1 are directly connected to each other and a source of the first FET is grounded. A gate of the second FET 2 is commonly connected to the connection point a between the drain and the gate of the first FET 1, a drain of the second FET 2 is connected to the current output terminal 7, and a source of the second FET 2 is grounded. A gate of the third FET 3 is connected to the input control terminal 6, a drain of the third FET 3 is connected to the power terminal 8, and a source of the third FET 3 is connected to a drain and a gate of the fourth FET 4 directly connected to each other and a gate of the fifth FET 5. The drain and the gate of the fourth FET 4 are directly connected to each other as described above and a source of the fourth FET 4 is grounded. A drain of the fifth FET 5 is connected to the common connection point a of the FET mirror connection circuit and a source of the fifth FET 5 is connected to the power terminal 8. A control voltage Vc is inputted to the input control terminal 6, an output current Io is outputted from the current output terminal 7, and a power voltage V_{DD} is applied to the power terminal 8.

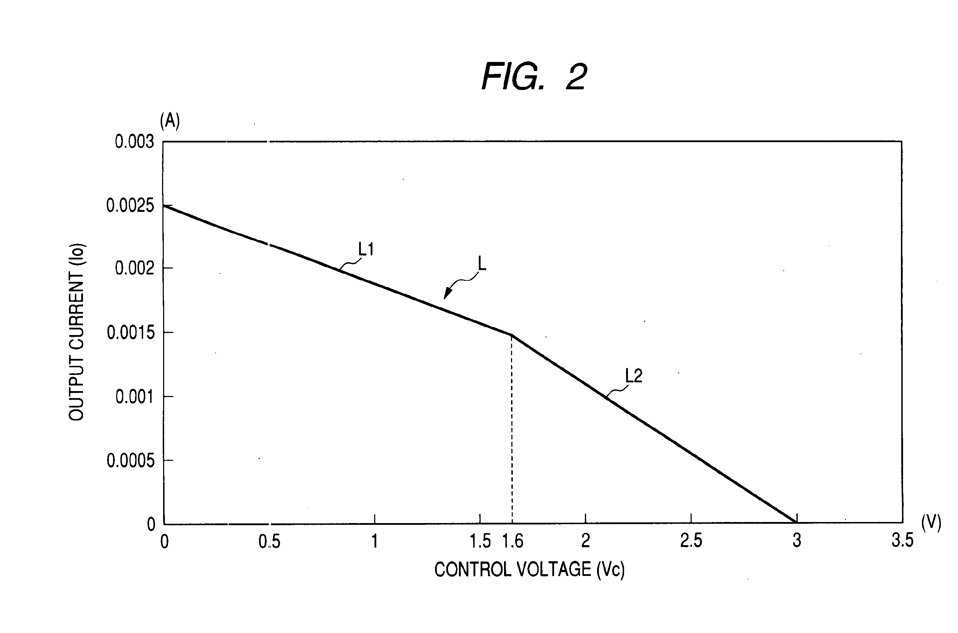

Next, Fig. 2 is a characteristic diagram showing a relationship between the control voltage Vc and the output current Io, which are controlled by the FET voltage-controlled current source shown in Fig. 1.

In Fig. 2, the horizontal axis is the control voltage Vc expressed in volts (V) and the vertical axis is the output current Io expressed in amperes (A). A characteristic curve L showing the relationship between the control voltage Vc and the output current Io is composed of a first straight line L1 having a relatively gentle slope and a second straight line L2 having a slope slightly steeper than the first straight line L1. In the characteristic curve, the first straight line L1 and the second straight line L2 is connected to each other at a voltage Vc corresponding to twice the voltage 2Vth (about 1.6 V) of a threshold voltage Vth (about 0.8 V) as a broken curve.

Here, operation of the FET voltage-controlled current source shown in Fig. 1 will be described. Fig. 2 is used in combination with Fig. 1 to describe the operation.

When a control voltage Vc is applied to the input control terminal 6, the control voltage Vc is applied to the gate of the third FET 3 constituting the source follower circuit to turn on the third FET 3. When the third FET 3 is turned on, the gate of the fifth FET 5 constituting the voltage inverting circuit is driven to turn on the fifth FET 5. At this time, a relationship between the source current flowing in the third FET 3 and the drain current flowing in the fifth FET 5 is as follows, that is, when the source current of the third FET 3 becomes large, the drain current of the fifth FET 5 becomes small, and when the source current of the third FET 3 becomes small, the drain current of the fifth FET 5 becomes large. For this reason, when the control voltage Vc applied to the gate of the third FET 3 becomes high, the drain current flowing in the fifth FET 5 is reduced, and when the control voltage Vc becomes low, the drain current flowing in the fifth FET 5 increases.

Then, when the drain current of the fifth FET 5 flows into the first FET 1 as the drain current, the same drain current as in the first FET 1 flows in the second FET 2 based on the operation principle of the FET mirror connection circuit composed of the first FET 1 and the second FET 2, and the output current Io equal to the drain current of the second FET 2 is derived from the current output terminal 7. Since the output current Io decreases as the control voltage Vc applied to the gate of the third FET 3 becomes high and increases as the control voltage Vc applied to the gate of the third FET 3 becomes low, the control voltage Vc and the output current Io have a relationship in which the output current Io decreases sequentially with increase in the control voltage Vc, as indicated by the characteristic curve L shown in Fig. 2.

In this case, the characteristic curve L shows that the output current Io decreases sequentially and linearly according to the first straight line L1 shown in Fig. 2 when the control voltage Vc increases sequentially from zero to twice the voltage 2Vth (about 1.6 V) of the threshold voltage Vth (about 0.8 V). Further, when the control voltage Vc increases sequentially over twice the voltage 2Vth (about 1.6 V) of the threshold voltage Vth (about 0.8 V), the output current Io decreases sequentially and linearly according to the second straight line L2. Finally, when the control voltage Vc increases to be the power voltage V_{DD} (3.0 V in the example of the characteristic curve shown in Fig. 2), the output current Io becomes zero being the minimum value.

As described above, according to the FET voltage-controlled current source, when the control voltage Vc applied to the input control terminal 6 changes from zero to the maximum value equal to the power voltage (3.0 V in the example of the characteristic curve shown in Fig. 2), the output current Io derived from the current output terminal 7 changes from the maximum value (0.0025 A in the example of the characteristic curve shown in Fig. 2) to the minimum value (0.0 A in the example of the characteristic curve shown in Fig. 2). Accordingly, it is possible to change the output current Io between the maximum value (0.0025 A) and the minimum value (0.0 A) in the almost whole variable range of the control voltage Vc. As a result, it is possible to eliminate a dead area where the output current does not change even though the control voltage Vc changes, and to increase the variable ratio of the output current Io to the control voltage Vc.

## Claims

1. A voltage-controlled current source comprising:
an FET mirror connection circuit in which a gate and a drain of a first FET are connected to each other and a gate of a second FET is commonly connected to a connection point between the gate and the drain of the first FET;
a third FET which has a source load and which is source-follower connected;
a fourth FET of which a gate and a source are directly connected to each other and a connection point between the gate and the drain is connected to a source of the third FET to become the source load; and
a fifth FET for inverting a voltage of which a gate is connected to a source of the third FET and a drain is connected to the common connection point of the FET mirror connection circuit,
wherein a control voltage is applied to the gate of the third FET and an output current corresponding to the control voltage is derived from the drain of the second FET.

2. The voltage-controlled current source according to claim 1,
wherein the control voltage changes between a power voltage value and a ground voltage value, and the output current changes between a maximum current value and a minimum current value corresponding to the change of the control voltage.
